(19) Europäisches Patentamt

European Patent Office

Office européen des brevets

(11) **EP 2 197 113 B1**

(12) **EUROPEAN PATENT SPECIFICATION**

(45) Date of publication and mention
of the grant of the patent:
**18.09.2013 Bulletin 2013/38**

(51) Int Cl.:
***H03K 17/16*** (2006.01)     ***G05F 3/26*** (2006.01)

(21) Application number: **09177772.2**

(22) Date of filing: **26.11.2008**

(54) **Controlled current source**

Gesteuerte Stromquelle

Source de courant contrôlée

(84) Designated Contracting States:
**AT BE BG CH CY CZ DE DK EE ES FI FR GB GR
HR HU IE IS IT LI LT LU LV MC MT NL NO PL PT
RO SE SI SK TR**

(43) Date of publication of application:
**16.06.2010 Bulletin 2010/24**

(62) Document number(s) of the earlier application(s) in
accordance with Art. 76 EPC:
**08020586.7 / 2 192 688**

(73) Proprietor: **ams AG
8141 Unterpremstätten (AT)**

(72) Inventor: **Singnurkar, Pramod
8052 Graz (AT)**

(74) Representative: **Epping - Hermann - Fischer
Patentanwaltsgesellschaft mbH
Ridlerstrasse 55
80339 München (DE)**

(56) References cited:
**WO-A-2006/120246     US-A- 5 111 205**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention is related to a controlled current source.

Controlled current sources are known from US 5,111,205 and WO 2006/120246. Current sources in integrated devices provide the required supply current and supply voltage to a plurality of sub-circuits, those sub-circuits providing different functions for the integrated device. Particularly, mobile or handheld devices require different supply voltages for their sub-circuits. Consequently, a DC supply voltage provided, for example, by a battery has to be converted into different supply voltage required by the sub-circuits.

It is common practice to use charge pumps for converting a first voltage into a second output voltage. The second output voltage can be higher than the first voltage, at which the charge pump is also referred to as voltage up-converter. Those charge pumps are connected to current sources providing the required current to the sub-circuits. In such cases, the charge pump comprises a reservoir capacitor, which may produce ripples across the output signal of the charge pump. It is therefore necessary that the current source must provide power supply ripple rejection (PSRR) means to prevent incorrect operation of sub-circuits connected to those current sources. Since the charge pump switching frequencies are relatively high, the power supply ripple rejection has to be achieved at such high frequencies.

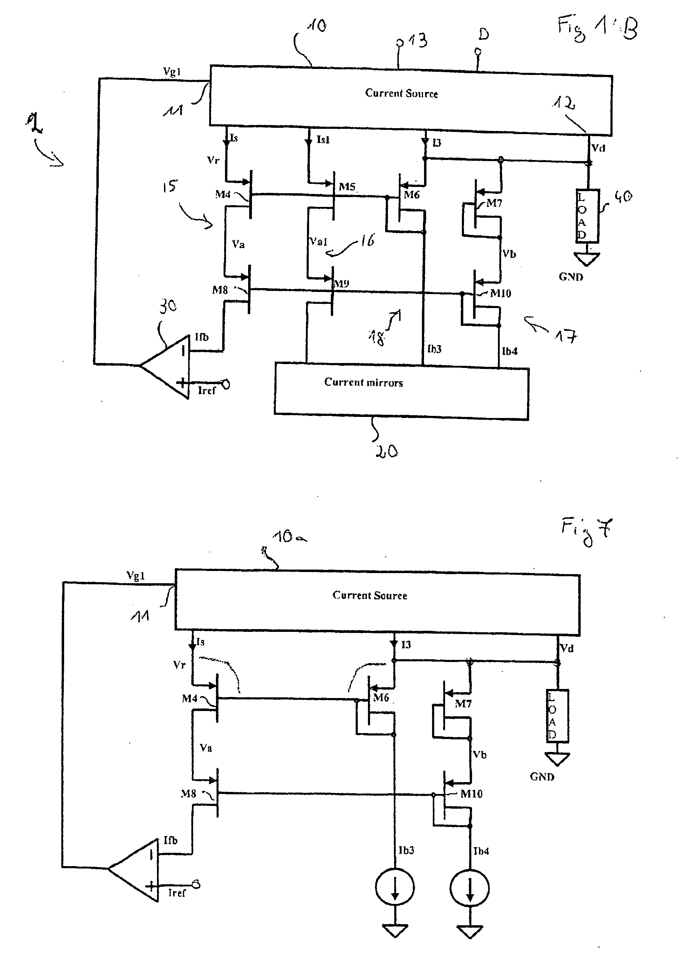

FIG. 7 shows a controlled current source according to the state of the art known to the inventor. The current source 10a comprises a control input 11 at which a control signal Vg1 is being applied. That control signal is derived by a comparison between a reference signal Iref and a feedback signal Ifb. The feedback signal is provided by a current sensing path comprising two transistors M4, M8 connected in series. Transistor M4 is part of a current mirror mirroring the sensed current Is to an output current 13.

Due to the presence of an AC component in the sensed current Is, the voltage signals Vr and the voltage output signal Vd defined by the load connected thereto are different. Further, the AC component of the current through the transistors M4 and M6 are different because no AC component is flowing through transistor M6. The current through the load is now given by internal switching transistors of the current source 10a, while the current in M6 and M7 is defined by Ib3 and Ib4.

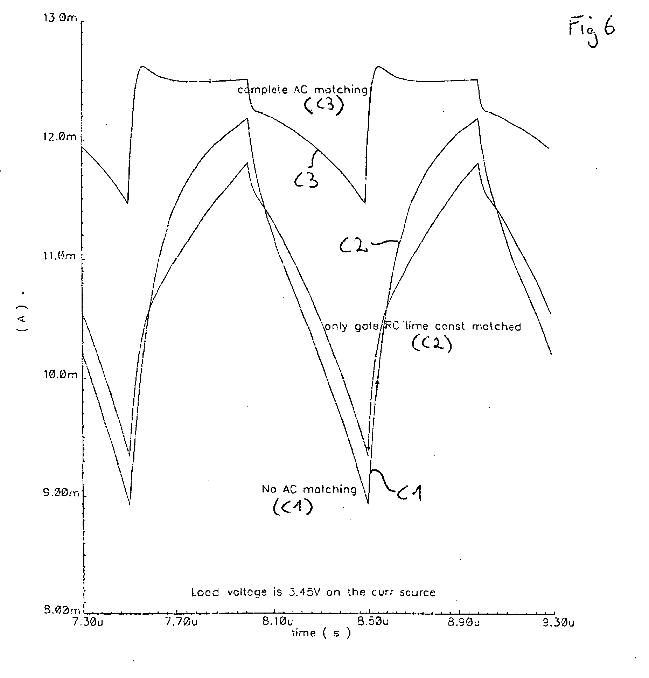

Nevertheless, ripples due to the switching frequencies of the charge pump connected to the current source 10a may become quite high and distort the overall output signal Io as illustrated in curve C1 of FIG. 6.

It is therefore desirable to provide an improved controlled current source with reduced power supply ripples.

This and other objectives of the present invention are solved by independent claim 1. Further embodiments and advantages of the present invention are presented in the dependent claims. A main aspect of the present invention is related to the improvement of matching of the output signal Vd and control reference signal Vr. This is achieved by improving the matching of the signal phases applied to several switching and controlled transistors of the current source. Particularly, RC time constants including the gate to source capacitances of the switching transistors within the current source are equalized while at the same time the AC components of the supply signal provided to the current source are mirrored into the output current.

According to the invention a controlled current source comprises a supply source, providing a supply signal having a DC and an AC component and an adjustable current source. The current source is coupled to the supply source and comprises switching transistors and switching devices coupled to the transistors to provide an output signal in response to an adjustment word and a control signal. The controlled current source further includes control means with a feedback circuit for providing the control signal based on signal provided by sensing means for sensing the DC and the AC component of the supply signal. Means for mirroring mirror the AC component in the supply signal and means for equalizing are provided to match the sensing means to the switching transistors and switching devices of the adjustable current source.

According to the invention the means for equalizing comprise at least one of a resistive element and a dummy transistor to match an RC time constant of the sensing means to an RC time constant of the switching transistors and switching devices. The means may also comprise a current path to provide a control current, said current path arranged between the supply source and the means for mirroring.

The adjustable current source may comprise a plurality of switching transistors arranged between the supply source and a current output terminal as well as a plurality of switching devices. The switching devices are adapted to be switched in response to the adjustment word. Each switching device is arranged between a respective gate of the plurality of switching transistors and a control signal terminal at which the control signal may be applied. The resistance of the switching devices and the gate-source capacitance of the respective switching transistors connected thereto are adjusted such that the RC time constants given by the each of the plurality of switching devices and the respective switching transistor connected thereto are substantially equal.

According to the invention, a controlled current source comprises an adjustable current source having a supply input terminal and an adjustment terminal. At the adjustment terminal, an adjustment word can be applied to adjust an output current provided by the current source. For this purpose, the current source comprises a plurality of switching transistors arranged between the supply input terminal and a current output terminal. The current source further comprises a plurality of switching devices to be switched in response to the adjustment word. Each switching device of the plurality of switching devices is arranged between a gate of each of the plurality of switching transistors and a control signal terminal. Finally, the controlled current source comprises a control circuit having a first current sensing path coupled to the supply input terminal to sense an AC portion of a supply signal and coupled to a current mirror to mirror said AC portion to the output current.

The first current sensing path may comprise a control transistor and a resistive element arranged between a gate of the control transistor and the control signal terminal. The additional resistive element connected to the gate of the control transistor allows to adjust the RC time constant given by the product of the resistive value and the gate-source capacitance of the control transistor to be substantially equal to the RC time constant of the resistive value of one of the switching devices and the gate-source capacitance of the respective switching transistor connected thereto. In other words, the path resistance-capacitance given by the gate to source capacitance of the respective switching transistors and the switching devices connected thereto are substantially equal. Consequently, any AC signal component coupled into the control signal terminal has substantially the same phase. AC matching is therefore improved.

In an embodiment, at least one of the switching devices of the plurality of switching devices comprises a first switch and at least a second switch arranged parallel or series to the first switch. Since each switch comprises a specific resistance, arranging a plurality of switches in parallel to each other receiving the same component of the adjustment word reduces the overall resistance of the switching device. The additional switches arranged in parallel can be used to equalize the RC constant given by the product of the resistive value and the gate-source capacitance of the switching transistor connected thereto to the RC time constant given by the product of the resistance and the capacitance of a second switching path.

Alternately, the current source may comprise at least one floating dummy transistor, said at least one floating dummy transistor coupled with its gate to the gate of the switching transistor of the plurality of switching transistors. The at least one floating dummy transistor and said switching transistor may comprise substantially the same size. Alternately, the dummy transistor may have different geometric dimensions compared to the switching transistors connected to the dummy transistor. The drain terminal of the dummy transistor may be floating.

The additional dummy transistor adjusts the gate-source capacitance of the switching transistor, thereby equalizing, as already explained above, the RC time constant given by the product of the resistance of the switching device and the gate-source capacitance of the switching transistor to respective other switching devices and switching transistors connected thereto.

Two adjacent switching transistors may comprise geometric dimensions or geometric size which differs by a factor of two.

According to the invention, the control circuit comprises a second current sensing path having a sensing transistor arranged in parallel to the sensing transistor of the first current sensing path. The sensing transistors of both current sensing paths may comprise the same geometric proportions and/or substantially the same gate to source capacitances.

While the first current sensing path comprises the current mirror transistor to mirror the AC signal portion of the supply voltage signal to the output current, the second current sensing path may be used to provide the DC portion. The gate terminal of the sensing transistor of the first and second current path may be coupled via a switching device to a reference current source.

The first current sensing path may also comprise a second reference source. As a result, the current sensed by the current sensing transistor of the second current sensing path may be regulated close to the difference of the reference currents of the first and second reference current sources.

In addition, the gate-source capacitance of the sensing transistors of both current sensing paths may be selected such that they are equal to $2^k$ times the gate-source capacitance of one of the switching transistors, wherein k is an integer. To satisfy such condition, the controlled current source may comprise in a further embodiment a dummy transistor. The gate of the dummy transistor is coupled to the gate of the sensing transistor of the first current sensing path. The size of the dummy transistor may be selected to satisfy the above-mentioned condition. Further, the dummy transistor may be floating.

Several embodiments and various aspects of the present invention will be described in greater detail with reference to the accompanying drawings in which

FIG. 1A    shows an embodiment of a controlled current source including a charge pump arrangement to provide the respective supply voltage,

FIG. 1B    shows an example of a controlled current source ac- cording to the present invention,

FIG. 2    shows a schematic of an embodiment of a current source being part of the controlled current source according to the present invention,

FIG. 3        shows an alternate embodiment of the current source according to the present invention,

FIG. 4        shows a further alternate embodiment of a current source according to the present invention,

FIG. 5        shows an embodiment of the control circuit accord- ing to the present invention,

FIG. 6        shows a time current diagram to illustrate the ef- fect of improved AC matching according to an em- bodiment of the present invention,

FIG. 7        shows a known controlled current source.

In the following detailed description, several aspects of the present invention are explained in greater detail with reference to the accompanying drawings. However, those features shown in the figures are not restricted to the respective embodiments, but can be combined in different ways by a person skilled in the art. The switches for the current source, the control circuit as well for other sub-circuits of the arrangement according to the present invention are implemented by field-effect transistors for illustration purposes. However, those switches are not restricted to field-effect transistors, but can be implemented in different ways. The clocked charge pump can be implemented in various ways and is therefore not restricted to any exemplary embodiment shown herein.

Some sub-circuits or elements are represented enlarged with respect to other elements. Such enlargement is for illustration purposes and does not reflect differences in real size when implementing those elements. The circuits and sub-circuits shown herein can be implemented in a single semiconductor body as an integrated circuit or as separated circuits using integrated as well as discrete components and devices.

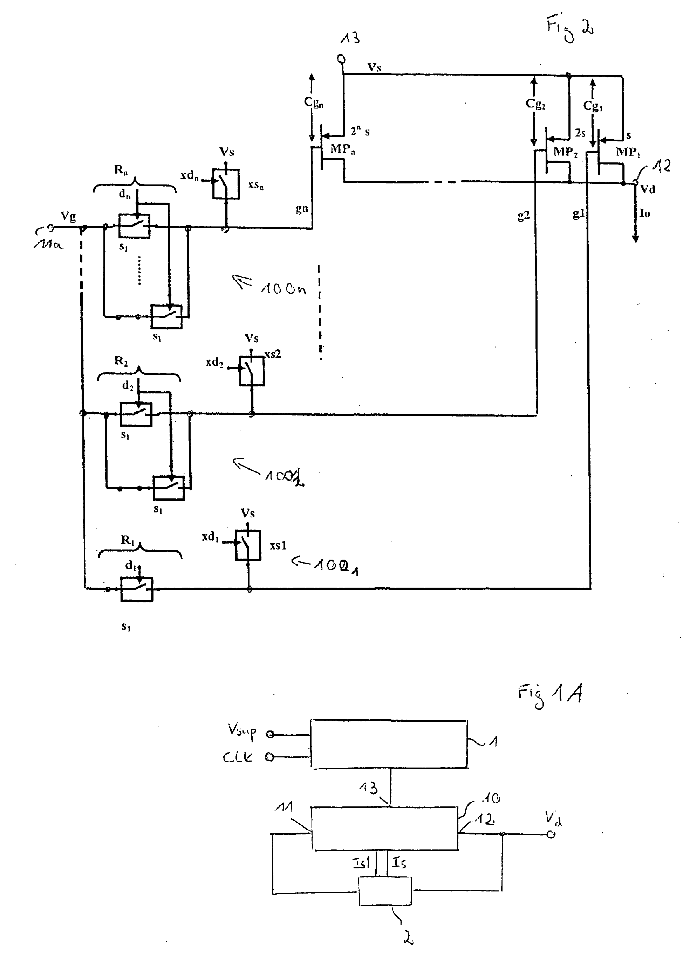

FIG. 1A illustrates an embodiment of a controlled current source including a charge pump arrangement. Charge pump arrangement 1 comprises a clock input terminal for clock signal CLK and a supply terminal Vsup. The clocked charge pump is operated in two successive periods of a cycle of signal CLK. In a first period of clock signal CLK, one or more capacitors are charged using the externally applied supply voltage Vsup. In a second period of clock signal CLK applied to clock input terminal, the charge stored in the capacitors is provided at an output terminal. Depending on the capacitors and the structure of charge pump 1, the output voltage provided at the output of the charge pump can be higher than the externally applied supply voltage Vsup. In any case, the controlled current source connected to the output terminal of charge pump 1 draws the charge provided at the output of the charge pump continuously. As a consequence, charge pump 1 may have to operate continuously, thereby producing ripples on its provided output voltage. The output voltage is dependent on the load connected to the controlled current source. The ripples may be in the range of 100 mV at 4 V output voltage and 100 mA current drawn from the output voltage.

The controlled current source comprises a current source 10 with supply terminal 13 connected to charge pump 1 and an  output terminal 12 at which a controlled output voltage Vd is provided. The output voltage Vd is dependent on the load connected to the output terminal 12.

A control circuit 2 of the controlled current source is connected to output terminal 12 of current source 10 as well as to a control signal terminal 11 of the current source. The control circuit 2 uses two current sensing paths Is1 and Is2 to sense the AC and DC portion of the current provided by current source 10. Due to some AC component in the supply voltage provided by charge pump 1, the voltages applied to gates of switching transistors within current source 10 may be different due to finite switch resistances of switches and gate-source capacitance of the switching transistors. The control circuit now senses the AC component and provides a respective control signal to the current source.

FIG. 1B shows a more detailed view of the controlled current source according to the present invention. The current source 10 comprises a supply terminal 13 at which the supply voltage from the charge pump (not shown) is received. Output terminal 12 providing the load voltage Vd is connected to load 40. In addition, the current source comprises a control signal terminal 11. To match the AC components and improve the charge pump ripple rejection, control circuit 2 comprises a first current path 16 as well as a second current path 15, both current paths sensing a current flowing through current source 10. The second current sensing path 15 comprises a current sensing transistor (not shown herein) as well as two field-effect transistors M4 and M8 forming a series circuit.

The current sensing provides the sensing current Is. The sensing current transistor is selected such that the sensed  current Is satisfies the equation $Is = s2/s * I_{LSB}$, wherein s2 is the width/length ratio of the current sensing transistor, s is the width/length ratio of one of the switching transistors of current source 10, explained later in greater detail, and $I_{LSB}$ represents the current through the switching transistor corresponding to the least significant bit of the current source.

The gate voltage Vg1 is controlled in such a way that the current through the sensing transistor of the second sensing path 15 satisfies the equation. This is achieved by comparing the current Is at terminal Ifb of comparator 30 with a reference current at terminal Iref.

The first current path 16 comprises transistors M5 and M9 connected in series with a current sensing transistor in the current source 10 (not shown) of the first current sensing path 16. The gate terminals of transistors M5 and M9 are connected to the respective gate terminals of transistors M4 and M8 of the second current sensing path 15. The sensed current Is1 is used to determine currents Ib3 and Ib4 of paths 17 and 18.

Since current Is1 is proportional to current Is of path 15, reference currents Ib3 and Ib4 will also carry proportionate AC components. Path 17 includes diode M7 and a further field-effect transistor M10 which represents the current mirror transistor to mirror the AC component of M10 to transistors M8 and M9 of current sensing paths 15 and 16, respectively. Diode M7 is also coupled to output terminal 12 of the current source. A second current path 18 with the reference current Ib3 comprises transistor M6 as well as a further transistor M3 (not shown herein), said transistor being part of current source 10. The transistor M3 provides current 13, being substantially equal to reference currents Ib3 and Ib4.

The AC component of the second path 18 is coupled via current mirror transistor M6 into transistors M4 and M5, respectively. As a result, the transistors M4 and M6 carry the same proportion of AC and DC signal components. Such structure is one aspect to improve the AC matching of the controlled current source according to the current invention.

FIG. 2 now illustrates a new switching arrangement of the current source to obtain equal gate voltages at the respective gates of the switching transistors.

The current source comprises a plurality of switching transistors $MP_1$ to $MP_n$ being arranged in parallel between supply input terminal 13 and output terminal 12. The transistors $MP_1$ to $MP_n$ each comprise a specified width/length ratio. Particularly, each transistor $MP_k$ of the transistors $MP_1$ to $MP_n$ comprise the width/length ratio satisfying the term (width/length $* 2^{k-1}$). Therefore, transistor $MP_1$ has half the ratio compared to transistor $MP_2$ and so forth.

Between each gate of the respective switching transistors and the supply terminal 13, a gate-source capacitance given by $Cg_1$ to $Cg_n$ can be specified. The gate terminals of each transistor $MP_1$ to $MP_n$ are connected to respective switching devices $100_1$, $100_2$ to $100_n$. Switching device $100_1$ comprises a single switch arranged between control terminal 11 and the respective gate of the first switching transistor $MP_1$. Further, a node between switch $S_1$ of switching device $100_1$ and gate of switching transistor $MP_1$ is connected to an additional switch xs1 being coupled to the supply potential Vs. Depending on the adjustment word D having the components $d_1$ to $d_n$, either switch s1 or switch xs1 of each switching device is closed while the other one is open. Accordingly, at gate of the switching transistor $MP_1$, either the voltage Vg from the control terminal 11 or the supply voltage Vs is applied. Consequently, each switching transistor of the switching devices $100_1$ to $100_n$ is either activated or deactivated in response to the adjustment word D. The second switching device $100_2$ comprises two switches s1 arranged in parallel. Each switch is closed or opened by the respective adjustment component $d_2$ of adjustment word D. Accordingly, switching device $100_n$ comprises n switches S1 arranged in parallel.

Each switch of the switching devices $100_1$ to $100_n$ comprises a resistance $R_1$, $R_2$ to $R_n$. The parallel arrangement of additional switches keeps the RC time constant of path resistance and gate-source capacitance equal to each other. For instance, product $R_1 * Cg_1$ equals $R_2 * Cg_2$ due to the fact that the second switching transistor $MP_2$ has twice the capacitance of the first switching transistor but $R_2$ is half the resistance of $R_1$. In summary, the arrangement equals the equation

$$R_1 * Cg_1 = R_2 * Cg_2 = \ldots = R_n * Cg_n.$$

As an overall result, the AC components $g_1$, to $g_n$ at the gates of the switching transistors $MP_1$ to $MP_n$ are substantially equal to each other.

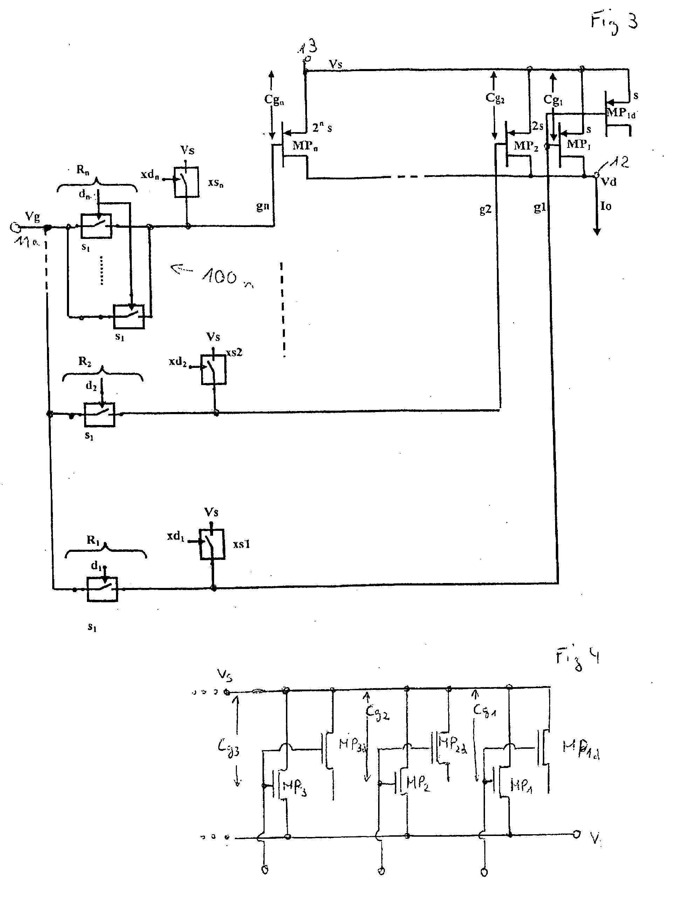

As an alternative embodiment, FIG. 4 shows an arrangement also improving the matching of the AC voltage components $g_1$ to $g_n$. In this embodiment, an additional dummy transistor $MP_{1d}$ is provided, said dummy transistor having a floating drain terminal. The dimensions of the dummy transistor are set equal to the dimension of the first switching transistor $MP_1$. The gate of the dummy transistor $MP_{1d}$ is connected to the gate of the first switching transistor $MP_1$.

As a result, the overall gate-source capacitance of the first switching transistor and the first dummy switching transistor equals the second switching transistor. In this respect gate-source capacitance represents the capacitance between the gate and the source terminal. Consequently, the resistance $R_1$ of the first switching device and $R_2$ of the second switching device can be equalized as well. In such case, the last switching transistor $MP_n$ is connected with its gate to a switching device $100_n$ comprising n-1 switches arranged in parallel.

In a further embodiment shown in FIG. 4, a plurality of dummy transistors $MP_{1d}$, $MP_{2d}$ and $MP_{3d}$ are connected to respective switching transistors $MP_1$, $MP_2$ and $MP_3$. The respective drain terminals of each dummy transistor are floating. The size of the dummy transistors $MP_{1d}$ to $MP_{3d}$ is selected such that the overall gate-source capacitance of a dummy transistor connected to the respective switching transistor is equal and satisfies the equation $Cg_1 = Cg_2 = Cg_3$. Consequently, the resistance of the switches $100_1$ to $100_3$ connected to the respective gates of the switching transistors $MP_1$ to $MP_3$ should be selected equal.

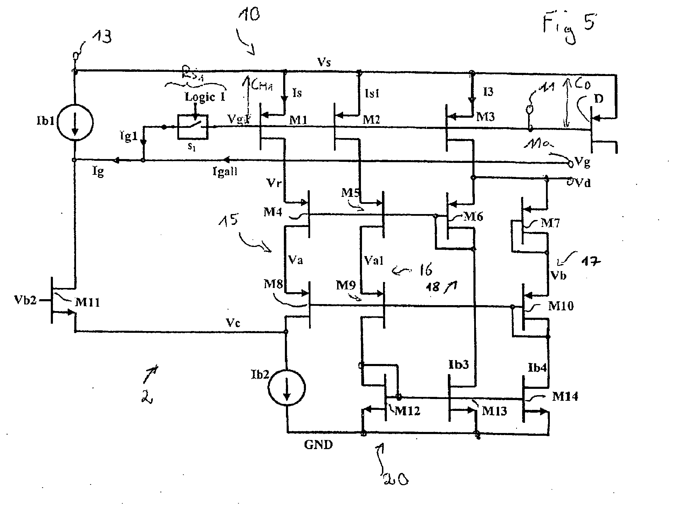

FIG. 5 shows an embodiment of a new regulation circuit according to the proposed current source.

The regulation circuit comprises four current paths 15, 16, 17 and 18, each of them having a plurality of transistors connected in series. Particularly, a first current sensing path 16 comprises a sensing transistor M2 as well as two transistors M5 and M9 connected in series and coupled to a current mirror transistor M12 of a current mirror 20. Current mirror transistor 12 of current mirror 20 mirrors the current into transistors M13 and M14 of respective current paths 17 and 18.

A second current sensing path 15 comprises sensing transistor M1 as well two transistors M4 and M8 connected in series and coupled to a reference current source Ib2. The gates of sensing transistors M1 and M2 are coupled to the gate of a third current transistor M3 providing the current for paths 17 and 18. Finally the gates of transistors M1, M2 and M3 are connected to a gate of a dummy transistor D and a switch S1. The purpose of dummy transistor D will be explained later in greater detail.

The voltage Vg1 applied to the gates of the respective transistors are provided by the comparator 30 as shown in FIG. 1B. In addition, a current source Ib1 is arranged between supply terminal 13 providing the supply voltage Vs and transistor M11. The gate of transistor M11 receives the bias voltage Vb2 and its drain is connected to the current source Ib2 of the second current sensing path 15.

A node between the reference current source Ib1 and the bias transistor M11 is connected to terminal 11 to provide the control voltage Vg. Said control voltage Vg is applied to terminal 11a of the circuits shown in Figures 2 and 3. Switch Rs1 connected to the gates of the respective current transistors M1, M2, M3 and the dummy transistor D is also coupled to said node.

In operation of the control circuit, the sensed current Is1 is used to define via current mirror transistor M12 the reference currents Ib3 and Ib4 of the current paths 17 and 18. Due to the fact that a sense current Is1 is proportional to the sense current Is of the second current path, the reference currents Ib3 and Ib4 will carry proportionate DC and AC components. In an embodiment, the size of current sensing transistors M1 and particularly of M2 is equal to the size of switching transistor $MP_1$.

Transistors M6 and M7 of current paths 17 and 18 are connected with their respective gates to their respective drain terminals, thereby forming a diode. Accordingly, the voltage drop over transistors M6 and M7 comprise an AC as well as a DC component. The AC component of transistor M6 is now mirrored to transistors M4 and M5 of the second and first current sensing paths, respectively.

The output voltage Vd is defined by a load connected thereto. The current drawn by the load is substantially provided by switching transistors $MP_1$ to $MP_n$ of the current source portion shown in Figures 2 and 3. Still, the current paths 17 and 18 will draw a current which is provided by the transistor M3. Therefore, the current 13 is similar to the current flowing through transistors M6 and M7 of current paths 17 and 18. Current 13 may also be a little bit smaller than the current through M6 and M7 wherein the remaining current is provided by the switching transistors MP. Current 13 therefore satisfies the equation

```
I3 = Ib3 +Ib4 + <some small rest provided by transistors MP>
```

Due to the current mirrors M6 and M10 of current paths 17 and 18, the voltage Vr of the second current sensing path equals the output voltage Vd.

In operation, the DC component of current Ig is substantially zero, because there are no currents flowing through the gates of the switching transistors as well as of the current sensing transistors. However, the AC component of current Ig is non-zero if the supply voltage Vs comprises an AC component, e.g. some ripples. Accordingly, the AC component in current Ig adds to the AC component of Is and Is1 leading to a ripple in sense current Is.

To improve the AC component matching of the control circuit as well as of the current source, a switch Rs1 is connected in series to the gates of the current sensing transistors M1, M2 as well as of transistor M3 and D. Although in this embodiment, only a single switch Rs1 is shown, it may be required to connect several switches in parallel or in series. The purpose of the switch RS1 is to equalize the RC time constants of the current (sensing) transistors M1, M2, M3 and D with the switching transistors and the switches connected thereto. The multiplication product of the path resistance between the gate-source capacitance of current sensing transistors M1 or M2 and the resistance of the switching device Rs1 connected to those gates should be equal to the multiplication product of the resistance of the switching device connected to the first switching transistor and the respective gate-source capacitance of the first switching transistor.

At the same time, the gate-source capacitance of transistors M1, M2, M3 and the dummy transistor D together is selected such that it is equal to $2^k$ times the gate-source capacitance of the first switching transistor $MP_1$, wherein k is a positive integer. In other words, equation 1 as well as equation 2 is to be satisfied wherein equation 1 is given by

$$RS1 * CM1 = R_1 * Cg_1$$

Wherein RS1 is the resistance of switch Rs1 and CM1 is the gate-source capacitance of Transistor M1. Equation 2 is given by

$$CM1 + CM2 + CM3 + CD = Cg1 * 2^k$$

wherein CM is the gate-source capacitance of the respective transistors M1 to M3 and D. The number of switches S1 connected in parallel is equal to k + 1.

In the above-mentioned condition, the AC component of voltage Vg1 and the voltages of the gates at the switching transistors $MP_1$ to $MP_n$ are all maintained the same. The accuracy of the feedback current Is is improved and the regulation circuit regulates the current Is close to the reference current Ib3 - Ib1. This will reduce the overall ripple in the output current 10 drawn by the load.

FIG. 6 shows a time current diagram illustrating the AC ripples in the output current.

Curve C1 shows the output current including some ripples without any AC component matching. The second curve C2 illustrates the output current if the gate-source capacitance of the respective switching transistors and the switching devices connected thereto are matched. As one can see, a small improvement is already achieved.

An even better improvement with only small ripples in the range of roughly 1 mA is illustrated in curve C3. This curve shows the output current of a current source according to the proposed embodiments including the resistance and gate-source capacitance matching of the transistors in the control circuit, the switching transistors as well as the additional current mirroring of the AC component to the output current.

The present invention proposes to improve the AC matching using weighted resistance switches or weighted gate-source capacitance to equalize the time constant between the several switching transistors and switches connected to the respective gates. Further, an additional sense current is used to improve the drain voltage matching.

**Claims**

1. A controlled current source, comprising:

   - a supply source, providing a supply signal having a DC and an AC component;
   - an adjustable current source (10) coupled to the supply source and comprising a plurality of switching transistors ($MP_1$, $MP_n$) arranged between the supply source and a current output terminal (12), and a plurality of switching devices ($100_1$, $100_n$) to be switched in response to an adjustment word, each switching device of the plurality of switching devices ($100_1$, $100_n$) arranged between a respective gate of the plurality of switching transistors ($MP_1$, $MP_n$) and a control signal terminal (11a) at which a control signal (Vg) is applicable;
   - control means with a feedback circuit for providing the control signal (Vg) based on signals provided by sensing means for sensing the DC and the AC component of the supply signal;

   **characterized in that** the controlled current source further comprises

   - means for mirroring the AC component in the supply signal to the current output terminal (12);
   - means for equalizing, which are configured to match the sensing means to the plurality of switching transistors ($MP_1$, $MP_n$) and the plurality of switching devices ($100_1$, $100_n$); and
   - a first and a second biasing current path (17, 18), each being directly connected to the current output terminal (12) and between the adjustable current source (10) and the means for mirroring;
   - wherein the sensing means comprise a first sensing path (16) and a second sensing path (15);
   - wherein the first sensing path (16) is directly connected between the supply source and the means for mirroring to provide the sensed AC component and comprises a series connection of a first sensing transistor (M2) in the adjustable current source (10), a first mirror transistor (M5) and a second mirror transistor (M9);
   - wherein the second sensing path (15) is directly connected between the supply source and the feedback circuit to provide the sensed DC component and comprises a series connection of a second sensing transistor (M1) in the adjustable current source (10), a third mirror transistor (M4) and a fourth mirror transistor (M8);
- wherein the first biasing current path (17) comprises a series connection of a diode (M7), which is connected to the adjustable current source (10), and a fifth mirror transistor (M10) having a gate terminal connected to gate terminals of the second mirror transistor (M9) and the fourth mirror transistor (M8) and being configured to mirror an AC portion of the first biasing current path (17) to both the first and the second sensing path (15, 16);
- wherein the second biasing current path (18) comprises a sixth mirror transistor (M6) having a gate terminal connected to gate terminals of the first mirror transistor (M5) and the third mirror transistor (M4) and beingconfigured to mirror an AC portion of the second biasing current path (18) to both the first and the second sensing path (15, 16); and
- wherein the means for equalizing comprise a resistive element (Rs1) and a dummy transistor (D), the resistive element being coupled in series to gate terminals of the dummy transistor, the first sensing transistor and the second sensing transistor (M1, M2) to match an RC time constant of the sensing means to an RC time constant of the switching transistors ($MP_1$, $MP_n$) and switching devices ($100_1$, $100_n$) being defined by the Gate-Source-Capacitances of the switching transistors ($MP_1$, $MP_n$) and resistances of the switching devices ($100_1$, $100_n$).

2. The current source according to claim 1, wherein the means for equalizing comprise the first biasing current path (17) to provide a control current.

3. The current source according to claim 1 or 2, wherein the RC time constants given by the each of the plurality of switching devices and the respective switching transistor connected thereto are substantially equal.

4. The current source according to any of claims 1 to 3, wherein the supply source comprises a clocked charge pump.

5. The current source according to any of claims 1 to 4, wherein the diode (M7) is coupled to the current output terminal (12).

**Patentansprüche**

1. Geregelte Stromquelle, Folgendes umfassend:

- eine Versorgungsquelle, die ein Versorgungssignal mit einer Gleichstrom- und einer Wechselstromkomponente bereitstellt;
- eine einstellbare Stromquelle (10), die auf die Versorgungsquelle aufgeschaltet ist und mehrere Schalttransistoren ($MP_1$, $MP_n$), die zwischen der Versorgungsquelle und einem Stromausgangsanschluss (12) angeordnet sind, und mehrere Schaltvorrichtungen ($100_1$, $100_n$) umfasst, die im Ansprechen auf ein Einstellwort zu schalten sind, wobei jede Schaltvorrichtung der mehreren Schaltvorrichtungen ($100_1$, $100_n$) zwischen einem jeweiligen Gate der mehreren Schalttransistoren ($MP_1$, $MP_n$) und einem Steuersignalanschluss (11a) angeordnet ist, an den ein Steuersignal (Vg) angelegt werden kann;
- eine Regeleinrichtung mit einem Rückkopplungsschaltkreis zum Bereitstellen des Steuersignals (Vg) auf Grundlage von Signalen, die durch Abfühleinrichtungen zum Abfühlen der Gleichstrom- und Wechselstromkomponente des Versorgungssignals bereitgestellt werden;

**dadurch gekennzeichnet, dass** die geregelte Stromquelle darüber hinaus umfasst

- eine Einrichtung zum Spiegeln der Wechselstromkomponente im Versorgungssignal zum Stromausgangsanschluss (12);
- Einrichtungen zum Ausgleichen, die dazu ausgelegt sind, die Abfühleinrichtungen an die mehreren Schalttransistoren ($MP_1$, $MP_n$) und die mehreren Schaltvorrichtungen ($100_1$, $100_n$) anzupassen; und
- einen ersten und einen zweiten Vorspannungsstrompfad (17, 18), die jeweils direkt zwischen der einstellbaren Stromquelle (10) und der Einrichtung zum Spiegeln an den Stromausgangsanschluss (12) angeschlossen sind;
- wobei die Abfühleinrichtungen einen ersten Abfühlpfad (16) und einen zweiten Abfühlpfad (15) umfassen;
- wobei der erste Abfühlpfad (16) direkt zwischen der Versorgungsquelle und der Einrichtung zum Spiegeln angeschlossen ist, um die abgefühlte Wechselstromkomponente bereitzustellen, und eine Reihenschaltung aus einem ersten Abfühltransistor (M2) in der einstellbaren Stromquelle (10), einem ersten Spiegeltransistor (M5) und einem zweiten Spiegeltransistor (M9) umfasst;
- wobei der zweite Abfühlpfad (15) direkt zwischen der Versorgungsquelle und dem Rückkopplungsschaltkreis angeschlossen ist, um die abgefühlte Gleichstromkomponente bereitzustellen, und eine Reihenschaltung aus einem zweiten Abfühltransistor (M1) in der einstellbaren Stromquelle (10), einem dritten Spiegeltransistor (M4) und einem vierten Spiegeltransistor (M8) umfasst;

- wobei der erste Vorspannungsstrompfad (17) eine Reihenschaltung aus einer Diode (M7), die an die einstellbare Stromquelle (10) angeschlossen ist, und einem fünften Spiegeltransistor (M10) umfasst, der über einen an die Gate-Anschlüsse des zweiten Spiegeltransistors (M9) und des vierten Spiegeltransistors (M8) angeschlossenen Gate-Anschluss verfügt und dazu ausgelegt ist, einen Wechselstromanteil des ersten Vorspannungsstrompfads (17) zu sowohl dem ersten als auch zweiten Abfühlpfad (15, 16) zu spiegeln;

- wobei der zweite Vorspannungsstrompfad (18) einen sechsten Spiegeltransistor (M6) umfasst, der über einen an die Gate-Anschlüsse des ersten Spiegeltransistors (M5) und des dritten Spiegeltransistors (M4) angeschlossenen Gate-Anschluss verfügt und dazu ausgelegt ist, einen Wechselstromanteil des zweiten Vorspannungsstrompfads (18) zu sowohl dem ersten als auch zweiten Abfühlpfad (15, 16) zu spiegeln;

- wobei die Einrichtungen zum Ausgleichen ein Widerstandselement (Rs1) und einen Scheintransistor (D) umfassen, wobei das Widerstandselement mit Gate-Anschlüssen des Scheintransistors, des ersten Abfühltransistors und des zweiten Abfühltransistors (M1, M2) in Reihe geschaltet ist, um eine RC-Zeitkonstante der Abfühleinrichtungen an eine RC-Zeitkonstante der Schalttransistoren ($MP_1$, $MP_n$) und Schaltvorrichtungen ($100_1$, $100_n$) anzupassen, die durch die Gate-Source-Kapazitanzen der Schalttransistoren ($MP_1$, $MP_n$) und die Widerstände der Schaltvorrichtungen ($100_1$, $100_n$) bestimmt sind.

2. Stromquelle nach Anspruch 1, wobei die Einrichtungen zum Ausgleichen den ersten Vorspannungsstrompfad (17) umfassen, um einen Steuerstrom bereitzustellen.

3. Stromquelle nach Anspruch 1 oder 2, wobei die RC-Zeitkonstanten, die durch jede der mehreren Schaltvorrichtungen und den jeweiligen daran angeschlossenen Schalttransistor bestimmt sind, im Wesentlichen gleich sind.

4. Stromquelle nach jedem der Ansprüche 1 bis 3, wobei die Versorgungsquelle eine getaktete Ladungspumpe umfasst.

5. Stromquelle nach jedem der Ansprüche 1 bis 4, wobei die Diode (M7) auf den Stromausgangsanschluss (12) aufgeschaltet ist.

**Revendications**

1. Source de courant commandée, comprenant:

- une source d'alimentation, fournissant un signal d'alimentation ayant une composante CC et une composante CA;

- une source de courant réglable (10) couplée à la source d'alimentation et comprenant une pluralité de transistors de commutation ($MP_1$, $MP_n$) disposés entre la source d'alimentation et une borne de sortie de courant (12), et une pluralité de dispositifs de commutation ($100_1$, $100_n$) devant être commutés en réaction à un mot de réglage, chaque dispositif de commutation de la pluralité de dispositifs de commutation ($100_1$, $100_n$) étant disposé entre une grille respective de la pluralité de transistors de commutation ($MP_1$, $MP_n$) et une borne de signal de commande (11a) à laquelle un signal de commande (Vg) est applicable;

- des moyens de commande avec un circuit de rétroaction pour fournir le signal de commande (Vg) sur la base de signaux fournis par des moyens de détection destinés à détecter la composante CC et la composante CA du signal d'alimentation;

**caractérisée en ce que** la source de courant commandée comprend en outre

- des moyens pour refléter en miroir la composante CA dans le signal d'alimentation sur la borne de sortie de courant (12);

- des moyens pour égaliser, qui sont configurés pour faire correspondre les moyens de détection à la pluralité de transistors de commutation ($MP_1$, $MP_n$) et à la pluralité de dispositifs de commutation ($100_1$, $100_n$); et

- un premier et un deuxième chemin de courant de polarisation (17, 18), chacun étant directement connecté à la borne de sortie de courant (12) et entre la source de courant réglable (10) et les moyens pour refléter en miroir;

- dans laquelle les moyens de détection comprennent un premier chemin de détection (16) et un deuxième chemin de détection (15);

- dans laquelle le premier chemin de détection (16) est directement connecté entre la source d'alimentation et les moyens pour refléter en miroir afin de fournir la composante CA détectée et comprend une connexion en série d'un premier transistor de détection (M2) dans la source de courant réglable (10), d'un premier transistor miroir (M5) et d'un deuxième transistor miroir (M9);

- dans laquelle le deuxième chemin de détection (15) est directement connecté entre la source d'alimentation et le circuit de rétroaction pour fournir la composante CC détectée et comprend une connexion en série d'un deuxième transistor de détection (M1) dans la source de courant réglable (10), d'un troisième transistor miroir (M4) et d'un quatrième transistor miroir (M8);

- dans laquelle le premier chemin de courant de polarisation (17) comprend une connexion en série d'une diode (M7) qui est connectée à la source de courant réglable (10), et d'un cinquième transistor miroir (M10) comportant une borne de grille connectée à des bornes de grille du deuxième transistor miroir (M9) et du quatrième transistor miroir (M8) et étant configuré pour refléter en miroir une partie CA du premier chemin de courant de polarisation (17) sur à la fois le premier et le deuxième chemin de détection (15, 16);

- dans laquelle le deuxième chemin de courant de polarisation (18) comprend un sixième transistor miroir (M6) comportant une borne de grille connectée à des bornes de grille du premier transistor miroir (M5) et du troisième transistor miroir (M4) et étant configuré pour refléter en miroir une partie CA du deuxième chemin de courant de polarisation (18) sur à la fois le premier et le deuxième chemin de détection (15, 16); et

- dans laquelle des moyens pour égaliser comprennent un élément résistif (Rs1) et un transistor fictif (D), l'élément résistif étant couplé en série à des bornes de grille du transistor fictif, du premier transistor de détection et du deuxième transistor de détection (M1, M2) pour faire correspondre une constante de temps RC des moyens de détection à une constante de temps RC des transistors de commutation ($MP_1$, $MP_n$) et des dispositifs de commutation ($100_1$, $100_n$), étant définis par les capacités grille-source des transistors de commutation ($MP_1$, $MP_n$) et les résistances des dispositifs de commutation ($100_1$, $100_n$).

2. La source de courant selon la revendication 1, dans laquelle les moyens pour égaliser comprennent le premier chemin de courant de polarisation (17) pour fournir un courant de commande.

3. La source de courant selon la revendication 1 ou 2, dans laquelle les constantes de temps RC données par le chacun de la pluralité de dispositifs de commutation et le transistor de commutation respectif qui y est connecté sont sensiblement égales.

4. La source de courant selon l'une quelconque des revendications 1 à 3, dans laquelle la source d'alimentation comprend une pompe de charge cadencée.

5. La source de courant selon l'une quelconque des revendications 1 à 4, dans laquelle la diode (M7) est couplée à la borne de sortie de courant (12).

Fig 2

Fig 1A

Fig 1 B

Fig 7

Fig 3

Fig 4

Fig 5

Fig 6

complete AC matching (C3)

C3

C2

only gate/RC time const matched (C2)

No AC matching (C1)

C1

Load voltage is 3.45V on the curr source

13.0m

12.0m

11.0m

10.0m

9.00m

8.00m

(A)

7.30u    7.70u    8.10u    8.50u    8.90u    9.30u

time ( s )

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5111205 A

- WO 2006120246 A